(19) Europäisches Patentamt
European Patent Office
Office européen des brevets

(11) **EP 4 779 330 A1**

(12) **EUROPEAN PATENT APPLICATION**
published in accordance with Art. 153(4) EPC

(43) Date of publication:
**22.07.2026 Bulletin 2026/30**

(21) Application number: **23952139.6**

(22) Date of filing: **13.09.2023**

(51) International Patent Classification (IPC):
**G01R 31/08** (2020.01)    **G01R 31/50** (2020.01)

(52) Cooperative Patent Classification (CPC):
**G01R 31/08; G01R 31/50**

(86) International application number:
**PCT/ES2023/070556**

(87) International publication number:
**WO 2025/056818 (20.03.2025 Gazette 2025/12)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(71) Applicant: **Telefónica, S.A.**
**28013 Madrid (ES)**

(72) Inventors:
• **RAMÍREZ PÉREZ, Alberto, José**
  **28013 MADRID (ES)**
• **RABADÁN BARROSO, Javier**
  **28013 MADRID (ES)**
• **TOCA GARCÍA, Manuel**
  **28013 MADRID (ES)**
• **PRIETO ANTÓN, Sergio**
  **28013 MADRID (ES)**

(74) Representative: **Herrero & Asociados, S.L.**
**Edificio Aqua - Calle Agustín de Foxá, 4-10, 2ºA**
**28036 Madrid (ES)**

(54) **ELECTROMAGNETIC DEVICE AND METHODS FOR CHECKING PIPE CONTINUITY, PRESSURE AND CALIBRATION**

(57)    An electromagnetic marker device (beacon) and methods that, through the use of this device, allow for rapid, accurate, repeatable, and auditable continuity, pressure, and calibration verification tests in a conduit of ducts for a fiber optic network. The device connects to two ends of ducts in a fiber optic network conduit and incorporates a resonant circuit capable of resonating at two different frequencies depending on the pressure inside one of the ducts to which the device is connected.

FIG. 6

EP 4 779 330 A1

## Description

## Object of the invention

The present invention is applied in the technical sector of fiber optic telecommunications and, in particular, presents a technical solution for carrying out pressure, calibration and continuity tests on network of buried ducts (e.g., microducts), by means of an electromagnetic device (beacon), which also allows the detection of the end of the buried microducts.

## Background of the invention

Fiber optic data distribution networks are increasingly used to provide broadband data connections to users. In some scenarios, due to a lack of available infrastructure for laying new fiber optic cables, it is necessary to construct new conduits before deploying the fiber optic network. The construction of these new conduits often requires digging new trenches (civil works), which significantly increases deployment costs, and for this reason, the use of microducts is a clear trend to minimize trench size and, consequently, deployment costs. Microducts are tubes for transporting optical fiber, with dimensions much smaller than traditional ducts (typically between 5 and 20 mm in diameter).

It is also quite common in deployments in some countries for them to be carried out without installing intermediate manholes or access points, or with a very limited number of them (for example, with the aim of minimizing costs, speeding up permits with the authorities, etc.). This means that in the future there will be no quick access to fiber optic conduit, making maintenance and operation difficult, as in many cases only the two ends of the duct are available/accessible.

Therefore, marking the conduit and recording its routing is particularly important, as it is necessary to know precisely where the conduit runs in case repairs are needed.

With this function, it is very common, for example, to use electromagnetic devices (called beacons because of their signaling function) buried at certain intervals along a conduit routing. Thanks to the placement of these devices, it is possible to detect where the conduit runs in the future using a simple beacon detector. It is also common to use this type of beacon to mark specific points in the fiber optic network (branches, splices, or connections, etc.). These beacons are not only used in telecommunications conduits, but also in other fields (water, energy, gas, sanitary pipelines, etc.).

The fiber optic network is called by different names depending on where the network ends, so we would have for example: fiber to the building (FTTB) or fiber to the home (FTTH).

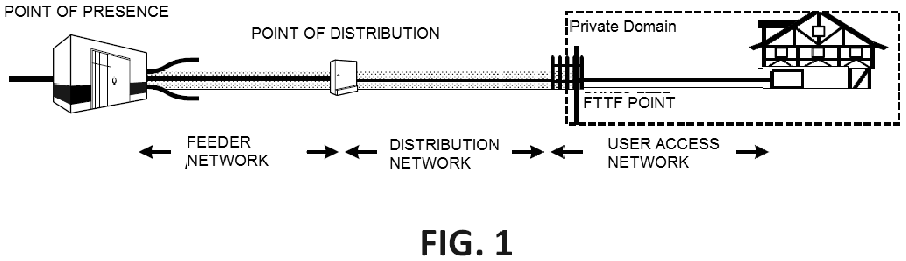

It is common for any new FTTH network to have different segments from the operator's central office (or point of presence) to customers' homes. Although this classification is not standardized, we could speak of three clearly differentiated sections: the feeder network, the distribution network, and the drop or user access network. The feeder network typically runs from a central office or point of presence (POP) to a distribution point (DP). A distribution point can serve multiple properties, and therefore, it usually consolidates a number of connections on the distribution side, reducing them to a single cable or two to the feeder network. The distribution network is the section that runs from the distribution point (DP) to the final breakout of the service drop, which then becomes part of the drop or user access network. The drop or user access network, within the private domain of each home/property, runs from the final breakout performed from the distribution network (shared by several properties) to each home/property (dedicated drop). This can be clearly seen graphically in Figure 1, which shows a basic diagram of the FTTH network.

In fiber optic networks, the concept of homes passed is used, which are those homes (residences) covered by a provider's fiber optic network in a given area or, in other words, homes that can potentially be connected to the fiber optic network in an area, if their owners were to contract the service since the fiber optic network is deployed in that area. It is quite common, during the deployment phase (when talking about homes passed) that the section of the drop network (user access network) is not deployed, and that it is only done when the customer is fully connected, once the fiber optic service has been contracted (that is, when it is not simply a home passed by a provider's network but a home that has contracted the service of said provider and is connected to its network). In certain cases, a partial deployment of the service drop may be carried out to reduce future connection costs for each customer (when they wish to connect to the network). This type of partial deployment is commonly called Home Pass Plus (HP+), or also FTTF point ("Fiber To The Fence"). These terms generally cover cases where fiber is brought to the fence, but also where the conduit (physical infrastructure of the fiber optic network) reaches the property fence. Figure 1 shows where the FTTF point would be located in the basic network diagram shown.

All network sections are inventoried and may be marked with electromagnetic beacons at the discretion of each operator. However, the specific points where future action is expected to be necessary are those where the use of electromagnetic beacons is most appropriate, as it is more likely that access to that point will be required in the future. One of the unique points that can be marked with electromagnetic markers (and is in fact common practice in the deployments of many operators in Europe) are the points where the customer service drop is broken-out from the distribution network, and also, more specifically, the point where the drop that will subsequently serve the property is buried (the FTTF or HP+ point).

The location of this point must be recorded with high precision and be easily locatable in the future, since when the property owner finally contracts the service, this point will be used as the starting point to continue the final section of the drop to the interior of the house. Given the importance of correctly locating these points, it is very common to record the exact location of the FTTF or HP+ point using GPS coordinates (usually requiring centimeter-level accuracy). It is also quite common to install an electromagnetic beacon at this point to allow location with a simple beacon detector, instead of requiring a high-precision GPS.

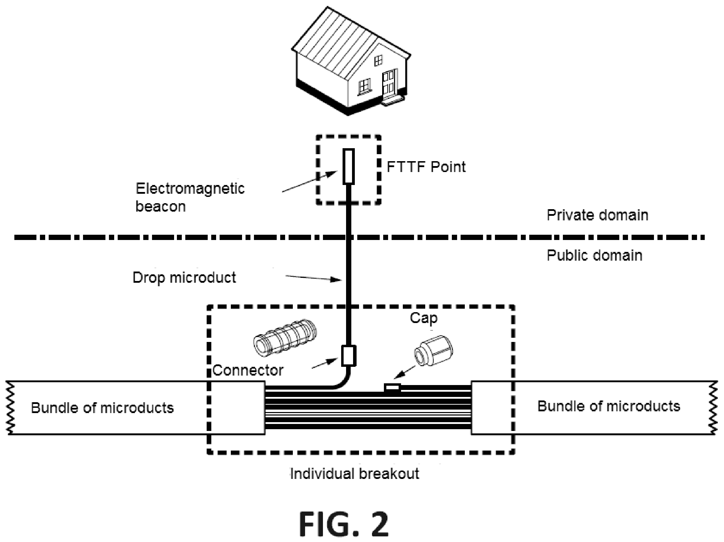

This is clearly shown in Figure 2, which illustrates a scenario where an electromagnetic beacon is used to mark the FTTF point in an individual breakout or, in other words, it marks the end of a drop microduct through which the home will connect to the fiber optic network when service is to be provided to that home. For this purpose, one end of the drop microduct is connected to the corresponding microduct in the distribution network using a connector, and the other end is connected to the electromagnetic beacon using a connector that will signal that point. The other end of the distribution network microduct is normally closed with a cap, as shown in the figure.

The FTTF point is just one example of a "singular" point that is signaled with a beacon in a fiber optic network, but there can be many other types of network points that, for one reason or another, need to be located and, therefore, may need to be signaled with a beacon in a fiber optic network.

There are different types of location beacons for these functions. There are many types of beacons, but here we will mention only some of the most common types available on the market:

- **Ball-type beacons.** This type of beacon can usually be detected at depths of between 2 and 3 meters (depending on the manufacturer and model). They typically include a mechanism that guarantees detection accuracy, regardless of how the beacon is installed (the resonant circuit is designed to emit perpendicular to the surface, and the beacon contains the necessary means for this: self-leveling system, fluids, etc.).
- **Flat disc-type beacons.** This type of beacon can be detected at depths of between 2 and 3 meters, provided it is installed in the correct position.
- **Cylindrical type beacons.** They are cylindrical beacons that can be detected at a depth of between 2 and 3 meters if installed vertically and at a maximum depth of approximately 0.6 meters if installed horizontally (that is, they are designed to have a greater range if installed vertically).

All these locator beacons typically incorporate a completely passive resonant circuit (usually a ferrite-core coil and a capacitor), which is detectable when excited by an electromagnetic signal at the appropriate frequency (a different frequency is usually used depending on the type of buried utility). This is what a beacon detector does: it emits an electromagnetic signal at the desired resonant frequency (or within a frequency range that includes the desired resonant frequency), and the presence of a beacon is determined at the point where it detects a return signal at that frequency (originating from the beacon's resonant circuit).

Depending on the application and the circumstances of the associated project, one type of beacon may be more suitable than another. Due to their physical shape, some beacons require more space for installation than others. For this reason, the beacon with the best performance is not necessarily the most appropriate for a specific application. For example, in the case of the FTTF or HP+ points mentioned above, it is possible to use minimally invasive techniques for their implementation (for example, a drill hole made with a diameter of less than 25 mm), which allow the installation of a dead-end microduct from the breakout of the distribution network to the desired FTTF or HP+ point. These techniques offer many advantages in execution, as they are very quick, do not damage the ground surface (street/sidewalk/garden), and do not require soil compaction for this small installation. However, these techniques do not allow the use of ball or disc type beacons, nor vertically installed cylindrical beacons, because their size prevents them from fitting through the hole. Therefore, horizontally installed cylindrical beacons are more suitable for these applications. This occurs because the drilling is done horizontally in a trench wall (in a real-world example, the horizontal hole might be 25 mm in diameter and about 50 cm long); therefore, it's easier for a horizontal beacon, following the direction of the drop microduct, to penetrate than a vertical one. Using cylindrical beacons installed horizontally reduces the depth at which they can be detected. However, in the final sections of the network, it's common to deploy the conduits (microducts) at depths ranging from 15 cm to 60 cm (greater depths are uncommon), so this type of beacon is perfectly suitable.

There are solutions on the market for placing the beacons horizontally in accordance with the application mentioned above. There are solutions that allow these beacons to be placed at the tip of a microduct, making them ideal for installation in situations such as the one described above (FTTF or HP+ implementation using the drill boring technique). There are different versions of the same solution concept that connect the beacon to the microduct in different ways: there are models with a direct connection to the microduct (ensuring watertightness and quick attachment with standard accessories/connection means) and others with indirect connections via a rubber sleeve that allows the beacon to be attached to the microduct, which has been previously sealed with a standard cap.

The inventory and marking (so that they can be easily detected later) of points of interest in a fiber optic conduit is, therefore, clearly resolved with the materials available on the market.

But when installing a conduit (for example, for a fiber optic network), in addition to marking certain points of interest (as explained above), it is necessary to guarantee the quality of the conduit. In the case of conduit installed with microducts, three main types of tests are typically performed:

- **Continuity verification test** (also called routing verification). This is an end-to-end test that ensures the branches have been installed correctly and according to the project plans. It is common to use microducts of different colors, and during deployment there is always a risk of color confusion when creating the branches, resulting in a situation that does not match the plan (i.e., the actual routing or path of a microduct may not be correct), and therefore testing is necessary.
- **Pressure test.** This test ensures that all connections made along a routing between different microducts are watertight and meet quality standards. It also checks for permanent damage to the microducts, such as cracks or fissures.
- **Calibration test.** This test aims to ensure that the microducts in a given routing maintain a minimum internal diameter so that cables with a diameter equal to or less than the tested diameter can be installed inside them. This is a crucial test, as during civil engineering construction, the microducts may be damaged by impacts or crushing, typically due to inadequate trench preparation (covering and sand bedding, etc.) or excessive pressure during soil compaction. These impacts or crushing can reduce the available diameter inside the microduct at that point, making it impossible for the fiber optic cable to pass through, thus preventing the deployment of the fiber optic network.

For the pressure test, it is sufficient to have only one free end of the duct (microduct) into which air is introduced through the circuit until the desired pressure is reached, and measure with a manometer (at the same end) that there is no drop or loss of pressure, since the other end will be capped and it is not necessary to have access to it to verify the test. In other words, at the same end where the air is introduced, the pressure loss in the circuit is measured. However, for continuity verification, until now, both ends of the duct have needed to be open: one to introduce the air and the other to check that the air exits where it should (i.e., that the different microducts have been properly spliced without mixing). This allows verification, from the distribution point to the customer, that everything is working correctly. For the calibration test, a proper caliper (mandrel type) is needed; one end is inserted and the other needs to be open to remove it and check that everything is correct (internal diameter of the microduct without damage); therefore, with the existing methods, it is also necessary to have both ends of the microduct accessible.

Performing these tests is essential to verify that the conduit is correct, as any of these faults would prevent the fiber optic network from being deployed and functioning properly.

However, on the other hand, performing these tests takes a considerable amount of time and, in most cases (except for pressure testing), requires access to both ends of the pipe to be tested (essential for continuity and calibration tests), therefore, if there are no manholes or inspection chambers available, open holes must be made at both ends of the pipes to be tested. The possibility of keeping the holes open continuously or indefinitely is practically unfeasible for safety reasons and due to public administration permits. The possibility of opening the holes each time the tests need to be carried out may also be unfeasible due to permit issues and very costly in terms of money and time, due to the amount of work required.

For these reasons, these types of tests are typically carried out during the civil engineering work for conduit installation. The problem is that these tests slow down the pace of construction (pressure and calibration testing takes considerable time), and for this reason, many builders are reluctant to perform them completely and often only carry out some of them partially (continuity verification tests and quick pressure tests). Furthermore, even when these tests are performed partially, it is not possible to audit or repeat them meaningfully due to the difficulties explained above. Therefore, for the contractor commissioning the conduit installation, it ultimately becomes an act of faith to determine whether the conduits have been installed in perfect condition or not.

Therefore, there is a need for a technical solution capable of minimizing the cost in time and resources involved in these tests, while still allowing them to be carried out accurately, as they are fundamental for the proper functioning of the conduit.

**Summary of the invention**

The present invention serves to solve the aforementioned problems by means of a new electromagnetic beacon that not only allows the location of one end of a fiber optic conduit to which it is connected to be indicated, but also allows continuity, pressure, and calibration tests to be performed on a fiber optic conduit in an improved manner with respect to existing procedures. Normally, these fiber optic conduits will be microducts.

Thus, the present invention provides a new electromagnetic device (also called a beacon because of its signaling function), and measurement methods that allow, through the use of this device, continuity, pressure and calibration verification tests to be carried out in a ductwork (microducts), in a fast, accurate, repetitive and auditable manner.

To perform the calibration test, access to both ends of the conduit to be tested is required. As mentioned previously, access to one end is usually available at the network distribution point. At the opposite end, access to the end of each microduct (the FTTF or HP+ point) would also be necessary to perform the calibration test. However, the device and procedure that is the subject of this invention allows the calibration test to be performed without requiring individual access points for each of the microducts to be tested, instead, a single access point (manhole, access chamber, or hole) can be used to test the calibration of all the microducts running through the same conduit (even with partial breakouts of service drops performed along the routing).

The present invention also saves resources and time since, among other things, the calibration test only requires access to both ends of the conduit. That is, one access point will be the network distribution point, and the other will be the end point of the conduit (which is common to several of the microducts to be tested), without needing access to each individual test point (the FTTF or HP+ point where the beacon is buried). And, as will be explained later, continuity and pressure tests can be performed without access to both ends of the microduct. Therefore, in most cases, there is no need to drill holes to perform these tests.

Specifically, in a first aspect of this invention, an electromagnetic device is presented for verifying continuity, pressure, and calibration in the ducts of a conduit, comprising:

- A resonant circuit whose resonant frequency varies from a first frequency, f1, to a second frequency, f2, when the pressure in a pressure-sensitive element of the resonant circuit is greater than a predetermined first pressure threshold;

- Two openings at one end of the electromagnetic device, where each opening is designed to connect to one end of a duct of the conduit (e.g., each opening has the appropriate physical shape to connect to a duct of the conduit via a standard connector or has appropriate means for connecting to a duct of conduit);

- An internal duct connecting, within the beacon, the two openings, where said internal duct has an orifice (which allows the transmission of air from the openings into the interior of the beacon);

- A casing (which houses and protects the resonant circuit).

In one embodiment, the resonant circuit includes two capacitors in parallel, connected at one end to a pressure-activated switch (pressure-sensitive element) that closes when the pressure received by the switch exceeds a predetermined first pressure threshold; or where the resonant circuit includes a capacitor (pressure-sensitive element) whose capacitance changes when the pressure it receives exceeds a predetermined first pressure threshold; or where the resonant circuit includes a coil (pressure-sensitive element) whose inductance changes when the pressure it receives exceeds a predetermined first pressure threshold.

In one embodiment, when the beacon is connected to two ends of ducts of the conduit through their openings, the pressure in the pressure-sensitive resonant circuit element depends on the pressure received (e.g., pressurized air) at the end of one of the ducts to which the electromagnetic device is connected. The first predetermined pressure threshold is typically high enough that the pressure in the pressure-sensitive element (which depends on the pressure received from one of the ducts of the conduit to which it is connected) reaches or exceeds that threshold only when there are no leaks in the conduit routing for that duct.

In one embodiment, the device comprises a first part having two openings and an internal duct, where the orifice of the internal duct allows air to pass through a channel to a pressure-measuring chamber located between this first part and a membrane, and wherein this membrane deforms when the pressure in the chamber increases and transmits this pressure increase to the pressure-sensitive element of the resonant circuit (thus, the pressurized air that has been introduced through one end of one of the ducts and reaches the beacon is transmitted to the resonant circuit to change it from one frequency to another).

The device may also include a second part secured to the first part by a retaining system, where the diaphragm is located between the two parts (or within the second part) and where this second part is secured to the housing. The connection between the first and second parts can be made by a retaining system capable of withstanding pressures of, for example, up to 16 bar. Thus, the first and second parts, and the second part and the housing, can be joined, for example, by a retaining system such as a threaded connection or a bayonet fitting.

In one embodiment, each of the openings has a cylindrical shape and an outside diameter suitable for connecting to the standard-sized duct conduit (e.g., via a standard duct connector).

In one embodiment, the conduit is a conduit of a fiber optic network and the ducts to which the device is connected are microducts.

In a second aspect of this invention, a method is presented for performing calibration tests on ducts of a conduit (for example, a conduit of a fiber optic network), using the electromagnetic device described above, wherein the method comprises:

a) Connect one of the openings of the electromagnetic device to one end of a first duct of the conduit and another opening to one end of a second of the conduit in a watertight manner;

b) Introduce a piece with a predetermined diameter through the other end of the first duct (the end not connected to the device, which may be located, for example, at a distribution point of the fiber optic network) along with pressurized air;

c) If the piece comes out of the end of the second duct (the one not connected to the beacon), then determine that the result of the calibration test performed is positive; that is, the first (and second) duct has a sufficient internal diameter (that of the gauge part) throughout its length (for example, a sufficient diameter to allow the fiber optic cable to pass through).

The described device, in addition to calibration tests, also allows for continuity and pressure verification tests. Therefore, this invention also presents a method for performing continuity and pressure verification tests on ducts in a conduit (for example, a fiber optic network conduit) using the electromagnetic device described above. The method comprises:

a) Connecting one of the openings of the electromagnetic device to one end of a first duct of the conduit and another opening to one end of a second duct of the conduit (this step is the same as step a) of the method for performing calibration tests);

b) Introducing pressurized air through the other end of the first duct (the end not connected to the device, which may be located, for example, at a fiber optic network distribution point);

c) Detecting the resonant frequency of the electromagnetic device and, if the resonant frequency has changed with respect to the resonant frequency of the device in the absence of pressurized air (i.e., it is not $f_1$ but $f_2$), then determining that the result of the test performed (continuity and/or pressure check) is positive.

These continuity and pressure tests can be performed, for example, before or after the calibration tests. Thus, the two methods presented can be combined into a single method where, after step a) (common to both), steps b) and c) of the first method are performed (to carry out the calibration tests), and then (or before) steps b) and c) of the second method are performed (to carry out the pressure and continuity tests).

In one embodiment, the pressure in the pressure-sensitive resonant circuit element depends on the pressure received by the end of the first duct to which the electromagnetic device is connected, and wherein, to perform the pressure test simultaneously with the continuity verification test, a predetermined first pressure threshold is set sufficiently high (e.g., high enough that the pressure in the pressure-sensitive element reaches this threshold when there are no significant leaks in the conduit routing, specifically in the first duct). This threshold might be, for example, 8 bar. In this case, if in step c) the resonant frequency has changed with respect to the resonant frequency of the device in the absence of pressurized air, then both the continuity verification test and the pressure test are deemed to be positive.

In one embodiment, if in step c) the resonance frequency does not change, then the pressure at the end of the duct through which pressurized air is introduced can be measured to determine whether it was a failure of the pressure test or the continuity verification test.

In one embodiment of the methods (both the method for calibration tests and the method for pressure and continuity tests), the ducts to which the device is connected are microducts.

In one embodiment of the methods, step c) is performed, with the ends of the ducts connected to the electromagnetic device and the electromagnetic device buried.

In one embodiment of the methods (both the method for calibration tests and the method for pressure and continuity tests), the conduit is a conduit of a fiber optic network and where the first duct is a duct that runs from the fiber optic network distribution point to the point of connection to a home, FTTF or HP+ point, and the second duct is a duct that runs from said connection point to the end of the bundle of ducts or end of line (or routing).

The scope of the present invention is defined by the appended independent and dependent claims. For a more complete understanding of the invention, its objects, and advantages, reference may be made to the following specification and the accompanying drawings.

## Brief description of the figures

The following section briefly describes a series of drawings that help to better understand the invention and that are expressly related to an embodiment of said invention, which is presented as a non-limiting example thereof.

FIGURE 1.- Schematically shows the different sections into which an FTTH fiber optic access network can be divided, with the FTTF (or HP+) point located in private domain.

FIGURE 2.- Schematically shows a scenario where an FTTF point is marked with an electromagnetic beacon.

FIGURE 3.- Schematically shows the connection of the beacon proposed in the present invention to two microducts, according to an embodiment of the invention.

FIGURE 4.- Schematically shows a variable resonant circuit of the beacon, whose resonant frequency varies with pressure, according to an embodiment of the invention.

FIGURE 5A.- Schematically shows a scenario where the beacons are connected in the state of the art.

FIGURE 5B.- Schematically shows a scenario where the beacons proposed in the present invention are connected to three different microducts at three different points of the network, according to an embodiment of the invention, and the pressure and continuity test is performed for one of them.

FIGURE 5C.- Schematically shows a scenario where the beacons proposed in the present invention are connected to three different microducts at three different points of the network, according to an embodiment of the invention, and the calibration test is performed for one of them.

FIGURE 6.- Shows an exploded view of the proposed beacon, according to one embodiment of the invention.

FIGURE 7.- Shows a view of the resonant circuit of the proposed beacon, according to an embodiment of the invention.

FIGURE 8.- Shows a cross-sectional (side) view of the beacon, according to an embodiment of the invention.

FIGURE 9.- Shows a cross-sectional (top view) of the beacon, according to an embodiment of the invention.

FIGURE 10.- Shows a view of a standard connector for connecting microducts.

**Detailed description of the invention**

Examples of embodiments of the invention are described in detail below, making reference where necessary to the figures cited above, without limiting or reducing the scope of protection of the present invention.

The electromagnetic device (beacon) proposed in the present invention is resonant at different frequencies and is connected to two (or more, although generally to two) microducts of a fiber optic conduit, so as to allow the location of a buried end of a duct, as well as allowing the verification and certification of (micro)ducts conduits by continuity, calibration and pressure.

The beacon is designed to be connected (in one embodiment, directly) to two ducts, typically two microducts, in a robust and completely airtight manner (there is no loss of pressure or airflow due to the beacon's connection to the ducts). In other words, the beacon must be able to connect to the microducts (in other words, be connectable to the microducts). In one embodiment, the beacon will have its own means of connecting to the microducts. However, in a preferred embodiment, the beacon will have the appropriate physical shape to connect to the (micro)ducts and, specifically, will have two access points or openings (usually tube-shaped) at one end, shaped to allow (quick) connection to the microducts using standard microduct connectors (as if it were a connection providing continuity between two microducts, but in this case, it will be between each microduct and the beacon). In other words, in one embodiment, the beacon must have two openings (also called inlets) at one end, physically resembling two ducts, each with the same or similar diameter as the microduct to which it will be connected. It will also have an internal connection (also called an internal duct or bypass circuit) that connects both inlets and is wide enough to allow a calibration mechanism (mandrel) to pass from one inlet to the other.

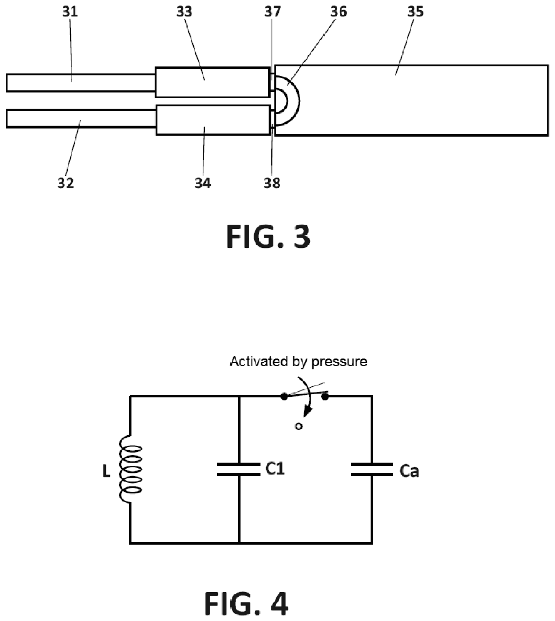

Figure 3 schematically shows the connection between two microducts (31, 32), two connectors (33, 34), and the marker beacon (35) that is the subject of this invention (on the right). Internally, the beacon forms a bypass circuit (36) interconnecting the two ducts (microducts) connected to it. This bypass is an internal duct/circuit that maintains at least the same internal diameter as the ducts to which it is connected, and its shape, in one embodiment, is half of a toroid. This allows the passage of a calibrated mandrel (a ball chain, for example) from one microduct to the other.

In other words, the beacon has an internal duct (36) that connects the two openings (37, 38) of the beacon, which in turn will each be connected to a microduct (when the beacon is installed in the conduit network)

Furthermore, the beacon must have, in the internal duct or bypass (36), an orifice that allows the pressure in the duct under test to be measured. In one embodiment, this orifice is very small and can be placed in the center of the bypass (or in any other position). This orifice does not affect the passage of the mandrel, which will be used in the calibration test, but it will allow air to pass into the beacon (and specifically into the resonant circuit so that the change in resonant frequency occurs, as will be explained later).

Therefore, this beacon will allow pressure and continuity testing (as explained below) and, additionally, allows the passage of a mandrel or ball chain from one tube to another, allowing (with the appropriate procedure and setup) the calibration test of the microducts.

Unlike existing beacons (whose circuits resonate at a single frequency), the beacon of the present invention incorporates a variable resonant circuit that can resonate at least at two different frequencies: at rest, it resonates at a first frequency $f_1$, and when one of the ducts to which it is connected is subjected to a pressure above a threshold ($U_1$), it resonates at a frequency $f_2$. The way in which the frequency change is carried out may vary depending on the embodiment.

A common embodiment of a resonant circuit at a specific frequency is a basic LC circuit, a circuit consisting of a coil (also called an inductor) and a capacitor in parallel. As is known, the inductance of the coil (L) and the capacitance of the capacitor (C) define the frequency at which the circuit resonates, given by the following formula (where the frequency f is measured in hertz (Hz), the capacitance C in farads (F), and the inductance L in henries (H)):

$$f = \frac{1}{2\pi\sqrt{LC}}$$

By changing the value of one of the two elements, for example the capacitor, the resonant frequency can be varied. Thus, as shown in the formulas below, changing the capacitance value of the capacitor (from $C_1$ to $C_2$, where $C_a$ is the difference between $C_2$ and $C_1$) allows us to change the resonant frequency (from $f_1$ to $f_2$).

$$f_1 = \frac{1}{2\pi\sqrt{LC_1}}$$

$$f_2 = \frac{1}{2\pi\sqrt{LC_2}}$$

$$C_2 = C_1 + C_a$$

This change in capacitor capacitance can be achieved in numerous ways. In one embodiment, for example, a push button/switch that is activated by pressure (when a pressure threshold is exceeded) can be used, adding capacitance to the resonant circuit. This is shown in Figure 4, which depicts a resonant circuit with two capacitors (with capacities $C_1$ and $C_a$, respectively) in parallel, connected by a pressure-activated switch. Below a pressure threshold ($U_1$), the switch is not activated, so the circuit's capacitance is that of the first capacitor ($C_1$), and therefore the circuit's resonant frequency is a first frequency ($f_1$). When the pressure rises above this threshold, the switch closes, so the circuit's capacitance becomes that of both capacitors ($C_1 + C_a$), and therefore the circuit's resonant frequency is a second frequency ($f_2$), different from the first. The circuit parameters ($L, C_1, C_a, U_1$) are design parameters of the device that will be chosen appropriately according to the desired operating characteristics.

Thus, for example, by conveniently choosing the circuit parameters and specifically, for example, the capacitances of the capacitors to be used, it is possible to make the circuit resonate at frequencies that are commonly used in commercial beacons to signal different services (as shown in the following table).

| APPLICATION | FREQUENCY |
|---|---|
| NON-POTABLE WATER | 66.4 kHz |
| TV CABLE | 77 kHz |
| GAS | 83 kHz |
| OPTICAL FIBER | 92 kHz |

(continued)

| APPLICATION | FREQUENCY |
|---|---|
| TELEPHONE | 101.4 kHz |
| SANITARY | 121.6 kHz |
| ELECTRICITY (EURO) | 134 kHz |
| WATER | 145.7 kHz |
| ELECTRICITY | 169.8 kHz |

Thus, for example, the first frequency $f_1$ could be the frequency used to mark buried telephone lines, 101.4 kHz, and the second frequency $f_2$ the frequency used to mark buried fiber optic lines, 92 kHz. This is just one non-limiting example, and other frequencies could be used depending on the services to be marked, the chosen criteria, etc. In general, by appropriately selecting the circuit parameters, it can resonate at the desired frequencies $f_1$ and $f_2$ (for example, depending on the application where the beacon will be used).

The pressure-activated switch/push button can be of any type. It can be any standard off-the-shelf component actuated by another system involving the movement of a stem or diaphragm, but it can also be a standard pressure switch or any device that fulfills the required function of being activated by pressure (or more generally, being pressure-sensitive). It doesn't even have to be a pressure-activated switch/pushbutton; a capacitor whose capacitance changes with pressure would also work.

In the embodiments described above, changing the circuit's capacitance value has been used to vary the resonant frequency. However, changing the inductance value of coil L, instead of the capacitor C's capacitance, to vary the resonant frequency with pressure would also be possible and is a potential embodiment of the present invention; although, in general, it might be more complicated to manufacture. It should be noted that the resonant circuit shown in Figure 4 is only a non-limiting example of an embodiment, and the proposed beacon could include any type of resonant circuit whose resonant frequency varies with the pressure received by the circuit (or, more specifically, the pressure received or detected by one of the pressure-sensitive circuit elements).

As explained below, installing a beacon like the one described above allows for continuity, pressure, and calibration testing of conduits in a novel and highly convenient way, both operationally and economically. This is due, among other things, to the fact that it allows continuity and pressure verification tests to be performed without requiring both ends to be open for proper testing. Additionally, it allows for easy calibration testing of several individual microduct breakouts (partial service drops, HP+, or FTTFs) from just two work points located at the common ends of the conduit.

Performing pressure tests, continuity checks, and calibrations with currently available materials is a very costly process. There are essentially two options: perform them during the construction work or afterward.

If testing is carried out during deployment (simultaneously with the open trenches), it slows down the work pace of the civil engineering team. Furthermore, it requires more specialized personnel to perform the tests and collect and interpret the results. If testing is done afterward, it becomes necessary to dig holes or test pits (with the significant cost this entails) to access both ends of the conduit to be tested (one end is usually accessible at the distribution point, but the other is typically buried, as it is the FTTF or HP+ point). Leaving the holes open indefinitely throughout the deployment period is practically unfeasible.

However, with the beacon described in this invention, which changes frequency with pressure and has a bypass for receiving the calibration mandrel, it is possible to perform all the tests in a simple, fast and precise manner, without slowing down the pace of the work and without having to open several holes afterwards to carry out the tests.

## Continuity and pressure verification tests

To perform the continuity verification test, with one end of the conduit available (for example, at the distribution point), it is possible to put pressure into each of the ducts independently, and with a standard detector verify (without needing to make any hole) that the duct being tested reaches the desired location (at the end of the microduct where the beacon is located), since, at that location and when pressure is introduced into the circuit at the other end, the resonant frequency of the beacon will change temporarily (until the pressure is removed).

In other words, if the actual duct routing is incorrect, the pressure will not reach the beacon located at the other end of the duct (for example, at point FTTF or HP+), and its resonant frequency will not change. If the actual duct routing is correct, the pressure reaches the beacon, and its resonant frequency changes. Therefore, with a beacon detector at the beacon's position (the end of the duct), continuity verification can be easily performed: if, when pressure is applied to the other end of the duct, the resonant frequency remains at the first frequency, then the continuity verification test is negative (the microduct routing is incorrect); and if, when pressure is applied to the other end of the duct, the resonant frequency changes to the second frequency, the continuity verification test is positive (the microduct routing is correct).

This method can also be used to perform the pressure test, as the beacon can be designed or calibrated to only change frequency at a sufficiently high pressure, ensuring there are no leaks along the rest of the conduit (since, if there were leaks, the correct pressure would never be reached at the beacon, and there would be no change in the resonant frequency). Therefore, if the beacon changes its resonant frequency when pressure is applied, it means the microduct connections are watertight and have no significant cracks or fissures.

Thus, whether the pressure test can be performed in conjunction with the continuity verification test will depend on the pressure threshold of the beacon, or more specifically on the pressure threshold (at the end of the duct) from which the resonant frequency of the beacon connected to the duct changes.

If this pressure threshold is low, for example 0.5-1 bar, then network continuity may be verified, but this would not be sufficient to guarantee network quality with the pressure test (i.e., if the beacon changes frequency, continuity could be considered verified, but the pressure test could not be guaranteed to be successful). If this threshold is sufficiently high (for example, 8 bar), then both tests could be considered passed if the beacon changes frequency (since the threshold for which the beacon was designed is sufficient to guarantee the pressure test).

In other words, if pressure is applied to one end of the duct and it is verified that the beacon (at the other end) has changed frequency, it indicates that the continuity verification test is successful, but it will only also indicate that the pressure test is successful if the pressure threshold of the beacon is high enough.

However, if pressure is applied and the beacon's frequency remains unchanged, then a continuity or pressure failure is suspected. However, it's impossible to determine which of the two (a lack of continuity or a leak in the network) is the cause. In other words, if the threshold is high enough and the beacon's frequency doesn't change, then the failure could be either related to continuity or pressure. However, in case of failure (the resonance frequency does not change), it would be possible to check if the pressure test is correct, since from the end where the pressure is introduced, the pressure could be checked (with a standard pressure gauge), and therefore determine the reason why the beacon does not activate (if the pressure gauge indicates that the pressure is correct, then it would be a continuity failure).

## Calibration test

In order to perform the calibration test in a joint (operationally viable) manner, the ducts to be tested are connected to a common point located at the end of the pipeline or line, as will be explained below.

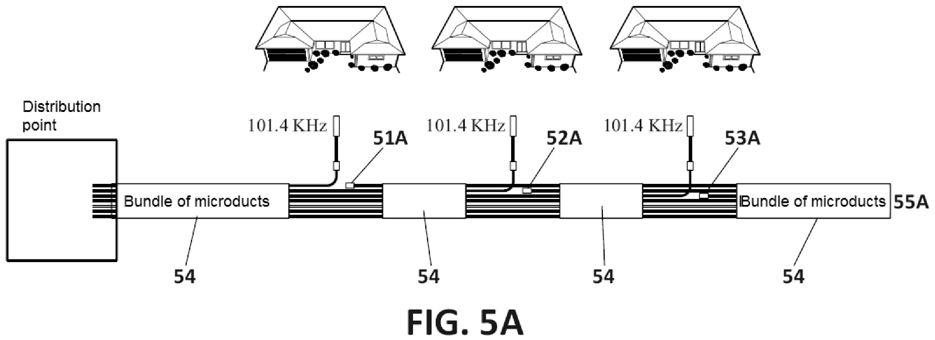

The distribution network typically originates from the distribution points in groups or bundles of microducts (54) that are installed buried in trenches running in front of the properties they are intended to serve. When an HP+ or FTTF installation is carried out, one of the microducts within that group or bundle is individually broken-out and connected to the property (to the FTTF point). To do this, one of the microducts is extracted (broken-out) from the bundle, and an individual connection is made which is the one that takes the fiber to the property (to the FTTF point). This provides an individualized microduct routing from the FTTF point to the distribution point. This type of breakout is performed repeatedly for each property to be covered. The bundle runs along the entire route (for example, a street or group of streets) from start to finish, and the breakouts are performed at the appropriate height. However, it is important to note that normally the size of the bundle of microducts remains constant from the beginning of the routing to the end of it, so that, even if breakouts have been carried out previously, the number of microducts available in the bundle remains the same, the only thing that happens is that the microducts that have already been broken-out, cease to have continuity to the point of distribution (they are left "dead," as they are often called in slang). This is the usual practice in the state of the art, as can be seen in Figure 5A, where the breakout ducts are shown and how they are "dead" at one of their ends (51A, 52A, 53A) since they are interrupted at the breakout point (usually by closing them with a cap as seen in the figure).

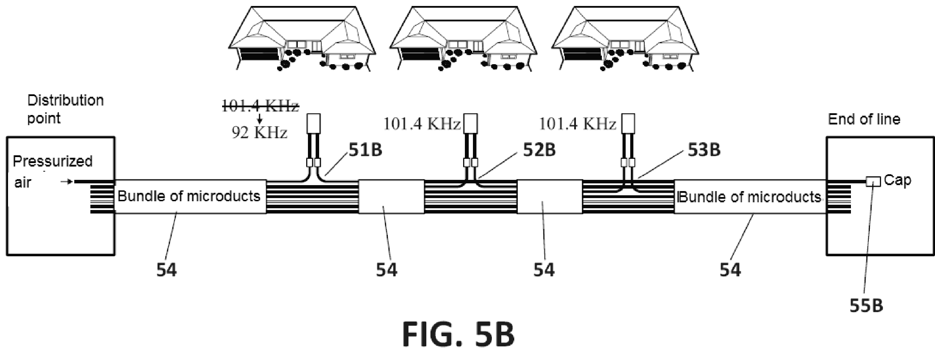

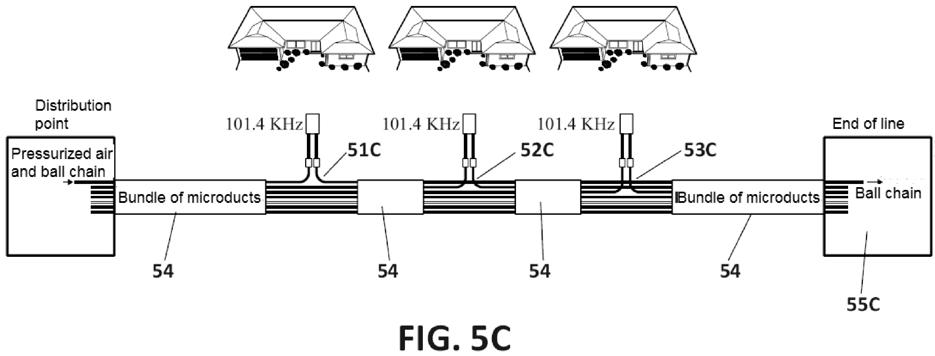

To perform the calibration test more efficiently, it is advisable to use these "dead" (micro)ducts, not by interrupting them but by providing continuity from the FTTF point to the end of the route. In this way, from the FTTF point, there is individual continuity to the distribution point (DP) in one direction, and also to the end of the line or end of the conduit bundle (54) in the opposite direction (as shown in Figures 5B and 5C). If we join both ducts at the FTTF point, we will therefore have end-to-end continuity between the distribution point (DP, 50), the starting point of the conduit (beginning of the pipe bundle), and the termination point of the line or conduit (end of the pipe bundle, 55A). The beacon of the invention allows this connection and also permits the passage of a calibrated boring system (ball chain) to perform the corresponding calibration test.

In other words, when a duct is broken-out from a bundle of ducts in the conduit (to prepare a service drop near a dwelling so that it can later be served if required), the duct is divided into two: a first duct that runs from the distribution point to the point where the dwelling will be connected to the network when needed (FTTF or HP+ point), and a second duct (which is no longer needed for fiber optic service) that runs from the breakout point to the end of the bundle of ducts (end of routing or line). In one embodiment of the present invention, the electromagnetic beacon is connected, at the FTTF point, to the ends of these first and second ducts (for this purpose, the second duct, which normally only reaches the breakout point, must be extended to the FTTF point).

The use of the beacon that is the subject of the invention for pressure testing, continuity verification, and calibration will now be explained with a graphic example.

Figures 5B and 5C schematically show a section of a distribution network that starts from the distribution point and follows the planned routing, serving different properties or buildings (this figure shows a network diagram using only three electromagnetic beacons to mark the FTTF points of three different properties; this is a simplification, but in general, the number of beacon-marked points in a network is much greater). As can be seen, in front of each property or building, a breakout of an individual microduct is carried out and at the end of each broken-out microduct a beacon is connected to signal the breakout point, according to an embodiment of the present invention. The network, except for the distribution point, is completely buried. The scenario shown in Figures 5 is only a simple, non-limiting example to illustrate the present invention. Of course, the present invention can be used with a greater or lesser number of beacons, each with different resonant frequencies.

The beacon marks the end of the drop microduct for each property or building, through which each dwelling will connect to the fiber optic network when service is desired. To do this, each drop microduct (in these figures, the first three microducts of the bundle) will be interrupted by connecting one end to the electromagnetic beacon that marks this point. However, as mentioned, the other end of the breakout microduct (51B, 52B, and 52B in Figure 5B and 51C, 52C, and 53C in Figure 5C) will not be left unconnected, but will be joined at the beacon (through the internal conduit). In this way, from the FTTF point, there is individualized continuity to the distribution point (DP) in one direction, and also to the end of the line or end of the duct bundle (54) in the opposite direction.

In the case shown in Figures 5B and 5C, the quiescent frequency of the beacons (without applying pressure to the microduct) is the same and it is $f_1 = 101.4$ kHz; therefore, at all FTTF points, the beacon could be located at the frequency $f_1 = 101.4$ kHz. This allows the beacon to be located and determines where a hole should be dug to retrieve the buried microduct. However, its quiescent function does not guarantee that the microduct breakout from the main bundle has been correctly made. In this specific example in Figures 5B and 5C, the second resonant frequency of the beacons is $f_2 = 92$ kHz.

To verify that the breakouts have been performed correctly, it is necessary to apply pressure to the microduct being tested, at its end (pressure and continuity test). Figure 5B shows the case where the pressure and continuity test is performed. In this particular case, pressure (compressed air) will be applied to the ends of the microducts located at the distribution point. When pressure is applied, for example, to the first microduct (the one serving the first house on the left), the frequency at which the beacon can be detected in the first house in the diagram changes from 101.4 kHz to 92 kHz. Since the beacon's resonant frequency has changed, this indicates that the continuity test is correct and that the pressure test is also successful. For the test to function correctly, the end of the microduct being tested (5B) must be properly sealed with a cap.

This same procedure can be followed for each microduct in the conduit, applying pressure to each microduct at one end and measuring the resonant frequency of the beacon at the other. It is essential to ensure that the breakout has been carried out correctly and that the network has been installed without damage (since a pressure threshold ($U_1$) must be exceeded for the frequency to change). If, when pressure is applied to the other end of the microduct to which the beacon is connected, the beacon's resonant frequency does not change, the test has not been passed, and therefore there has been an error in the installation of that microduct.

In the case of performing the calibration test (Figure 5C), a calibration piece (usually metallic) is inserted into one end of the microduct to be tested. This piece (usually called a mandrel or mandrel system or mechanism) has a predetermined diameter, such that if it passes through the conduit from one end to the other, it means that the conduit has a sufficient internal diameter along its entire length to allow the passage of the desired fiber optic cable without any problem. In one embodiment, this mandrel is a ball chain, for example.

Once the piece is inserted, compressed air is applied, causing the ball chain to circulate through the microduct being tested, passing through the bypass beacon located at the FTTF and reaching the end of the line (55C) if the routing is undamaged. This can be done individually for all microducts originating from the same DP and terminating at the same routing or conduit endpoint. In other words, it can be performed for all microducts in a bundle without requiring individual access to both ends of each microduct (at the FTTF or HP+ point), since the proposed beacon ensures that all microducts in the bundle begin and end at the same location (instead of being interrupted, as in the prior art).

This calibration test can be repeated for each breakout duct in the conduit (or a specific bundle of ducts within the conduit) to verify that all ducts are correctly installed.

A beacon, according to an embodiment of the invention, is then described and presented as a non-limiting example.

In one embodiment, the electromagnetic beacon of the present invention may be composed of different elements to achieve the following desired functionalities: firstly, having a resonant circuit (for example, an LC circuit) inside the beacon, which allows the resonant frequency of the circuit to change based on a certain pressure; and secondly, having a watertight connection of the beacon to two ducts (microducts) of the conduit network (joining them internally with an internal duct); or more specifically, to two ends of ducts in the conduit network. Typically, as explained above, a conduit in the conduit network is cut, resulting in two (sub)ducts, the ends of which are connected to the beacon.

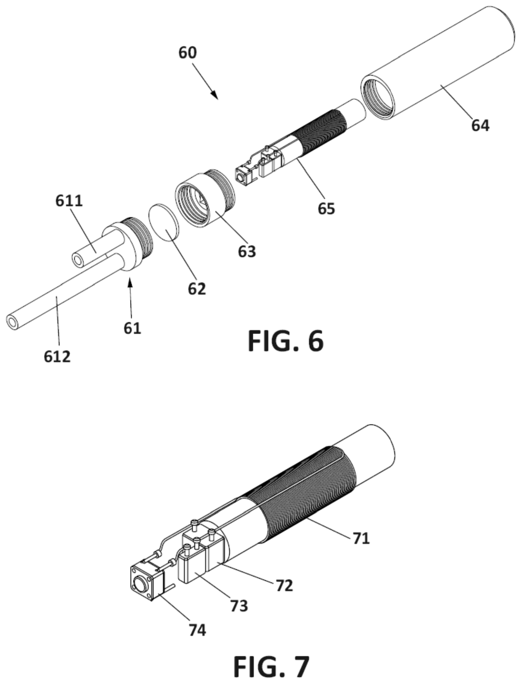

Figure 6 shows an exploded view of the proposed beacon, illustrating its main components according to one embodiment of the invention.

In this embodiment, the beacon (60) would consist of the following main parts (this is only a non-limiting example, and other embodiments may contain different components and a different number of components):

- A part (61) that allows connection to two microducts, with an internal bypass (internal duct) connecting the two ends of the connected microducts. This part (61) for coupling two ducts or tubes of the conduit (microducts) must also have a small air passage channel or pressure port (e.g., a hole in the internal duct) that allows air to pass to a pressure measuring chamber located downstream. This channel would be rear-facing, in the sense that it would normally be on the opposite side from the side designed to connect to the microducts (which is considered the front side of the beacon).

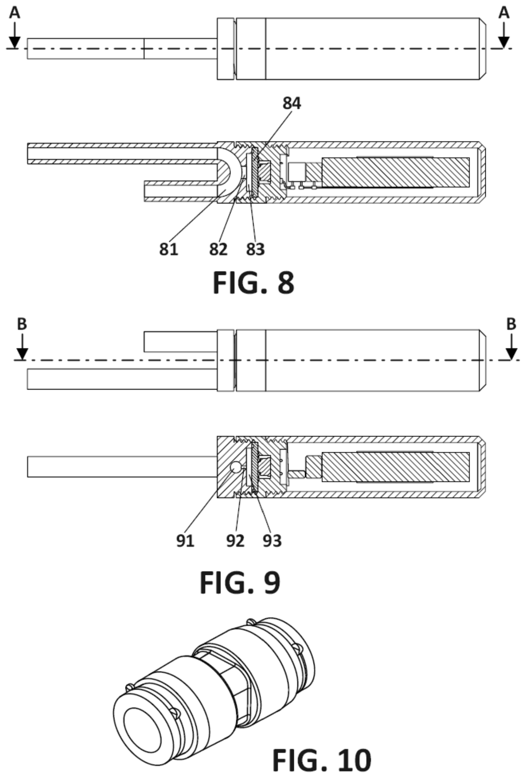

This part, on one hand, must be suitable for coupling with (standard) connectors that connect it to the microducts. In one embodiment, as shown in Figure 6, this part will have two openings (611, 612) on one side, with a shape (which could be cylindrical) and an outside diameter appropriate for connecting each to a microduct of standard dimensions. These openings are elongated/longitudinal (in one embodiment, as shown in Figure 6, they will be cylindrical); at one end they will connect to one end of a microduct and at the other to the internal duct (bypass) that joins the two openings within the beacon. In one embodiment, the connection between the beacon (specifically, the two openings of this part) and each microduct will be via a standard connector for connecting ducts in a conduit (and more specifically, microducts). Figure 10 shows one of these connectors.

On the other side (opposite where it connects to the microducts), this part will be adapted to the cavity or chamber where the pressure measurement will be taken. This part may include a retention system with the next part; this could be a threaded connection, bayonet fitting, or any other system capable of withstanding sufficient pressure (for example, up to 16 bar).

- A rubber gasket or membrane (62) creates a watertight seal against the part that connects to the microduct and also against the subsequent part that will secure the rest of the beacon. The space between the first part and the rubber membrane forms a pressure chamber.

- A part (63) designed to be fastened on one side by means of a threaded or crimp system (or any other known joining system) against the first part (61), and which, at this joint, exerts perimeter pressure on the elastic rubber diaphragm (stem or similar element) located between the two parts. This joint is airtight, withstanding a pressure of, for example, up to 16 bar. Between the diaphragm and this part (63) there is also a small cavity designed to allow deformation of the diaphragm when the pressure in the pressure chamber increases. In this way, the pressure applied through one end of one of the connected microducts, reaching the beacon, deforms the membrane. This deformation activates the pressure-activated element of the resonant circuit, causing a change in the resonant circuit's frequency. In one embodiment (where the resonant circuit is of the type shown in Figure 4), the membrane deformation activates the push button located directly behind it, adding capacitance $C_a$ to the LC resonant circuit, thus changing its resonant frequency from one to another. In this embodiment (where the resonant circuit has a pressure-activated switch/push button as shown in Figure 4), this second cavity is connected to a space, which may be an orifice, where a switch/push button is positioned. This switch/push button, when it receives sufficient pressure, modifies the resonant circuit, changing it from $f_1$ to $f_2$. The push button is positioned so that its movable stem or push button is in contact with the rubber diaphragm. An increase in pressure in the pressure chamber will deform the rubber diaphragm, actuating the push button and thus modifying the resonant circuit. It can be said that this part (63) therefore provides support for both the diaphragm and the pressure switch, or, more generally, the pressure sensor of the resonant circuit.

- This part (63) is also designed to be secured with a part (64) or housing that would contain the core of the resonant circuit (65), whose resonant frequency varies with pressure (in the specific example in Figure 6, it is a two-frequency resonant circuit with a pressure switch). In one embodiment, this housing (64) is cylindrical and designed to securely house the resonant circuit and protect it from the environment in which it will be installed (usually buried), by covering it appropriately. That is, in this embodiment (which is a non-limiting example), there would be 5 parts: 4 parts (61-64), usually plastic (although they could be made of another material), plus the resonant circuit as a whole.

- Resonant circuit: As indicated, the resonant circuit could be of any type in which the resonant frequency varies when the pressure exceeds a certain threshold. In one embodiment (shown in Figure 7 and based on the resonance scheme shown in Figure 4), it can consist of: a coil (71) with inductance L, for example, formed by a ferrite cylinder and a copper loop surrounding it; the ends of the beacon connected to a capacitor (72) with capacitance $C_1$; and in parallel, another capacitor (73) with capacitance $C_a$ in series with a pressure-activated push button/switch (74); connected in parallel to the capacitor of capacitance $C_1$ and the coil L (in one embodiment, the coil could be formed by a ferrite cylinder and a wire of conductive material, copper or similar). When the pressure rises above a certain threshold, the switch closes, the capacitance of the circuit changes (from $C_1$ to $C_1 + C_a$), and thus the resonant frequency varies.

Figure 8 shows a cross-sectional view of the beacon, according to one embodiment of the invention, with all its parts assembled. The internal bypass (81) for the passage of the calibration balls and the pressure gauge channel (82), or in other words, for the passage of pressurized air entering through one of the connected microducts, can be seen. This channel is small enough not to obstruct the passage of a string of boring balls used in the calibration test. The figure shows how the pressure chamber (83), which receives pressure from the channel, is located next to the diaphragm (84) so that, once pressure is applied to one end of the microduct, the pressure will reach the diaphragm through the channel, causing it to deform, press the button, and change the frequency of the resonant circuit. Thus, using a device that detects the frequency of the resonant circuit, it is possible to detect from the surface (without the need to make any hole) whether the continuity and pressure tests are correct (if the resonance frequency has changed).

In the following cross-sectional view (Figure 9), the internal bypass for the passage of the calibration mandrel (91) and the channel (92) for the pressure passage to the pressure chamber (93) can be seen. It is clear that the dimensions of this channel (or hole) on a shaft are very small compared to the circular section of the internal bypass (91), thus allowing the passage of the calibration mandrel (balls) without problems.

In summary, this text describes an electromagnetic marker device (beacon) designed (with two openings) to be hermetically sealed and connected to two different ducts (microducts). These openings (also called inlets) are connected by an internal bypass within the beacon, allowing a mandrel mechanism (ball chain) to pass from one opening to the other. This bypass also allows air to flow from the ducts into the beacon. The beacon incorporates an internal resonant circuit (for example, an LC circuit with a coil and capacitor) capable of resonating at two different frequencies depending on the pressure inside one of the microducts to which the device is connected.

This device not only allows the location of the ends of the (micro)ducts to which it is connected, but also allows (by performing the corresponding procedures) verification of the correct installation of the duct network.

Specifically, this device allows for verifying the continuity of (micro)ducts in a conduit without needing access to one end (i.e., with one end completely buried). It also allows for pressure testing, verifying that the beacon changes frequency at each point in the network where it is buried (indicating sufficient pressure at that point and therefore no leaks or significant damage to the conduit).

Furthermore, the device allows for a calibration test of the conduit of (micro)ducts, without needing to have the point to be tested accessible (the FTTF or HP+ point, where the beacon is buried) and with a single accessible point at the end of the route or common line for several pipes (ducts).

Although in many of the embodiments set out in this text, the present invention is applied in microducts of a fiber optic conduit, that is only a non-limiting example, since the present invention can be used in any type of ducts/conduits/pipes of conduit without being limited by the dimension of the same or its use (it could be for gas, water...).

In this text, the word "comprises" and its variants (such as "comprising," etc.) should not be interpreted in an exclusive manner; that is, they do not preclude the possibility that what is described includes other elements, steps, etc. Likewise, in the claims, the expression "comprising" does not exclude other elements or steps, and the indefinite article "a" does not exclude a plurality. No reference symbol in the claims should be interpreted as limiting the scope.

The specific design of each element and component shown in the figures is for illustrative and example purposes only; in no case is it intended to limit the design of each component only to that shown in said figures.

The aspects defined in this detailed description are provided to aid in a thorough understanding of the invention. Accordingly, those skilled in the art will recognize that variations, changes, and modifications to the embodiments described herein may be made without departing from the scope of the invention. Likewise, descriptions of well-known functions and elements are omitted for the sake of clarity and conciseness.

Having sufficiently described the nature of the invention, as well as how to carry it out in practice, it should be noted that its different parts may be manufactured in a variety of materials, sizes and shapes, and variations may also be introduced into its constitution or procedure as practice may advise, provided that they do not alter the fundamental principle of the present invention.

**Claims**

1. Electromagnetic device (60) for verifying continuity, pressure and calibration in ducts of a conduit, comprising:

   - A resonant circuit (65) whose resonant frequency varies from a first frequency, $f_1$, to a second frequency, $f_2$, when the pressure in a pressure-sensitive resonant circuit element is greater than a predetermined first pressure threshold;
   - Two openings (611, 612) at one end of the electromagnetic device (60), where each opening is designed to connect to one end of a duct of the conduit;
   - An internal duct (81) connecting, within the beacon, the two openings (611, 612), wherein said internal duct (81) has an orifice;
   - A housing (64) that houses and protects the resonant circuit (65).

2. Electromagnetic device (60) according to claim 1, wherein the resonant circuit (65) includes two capacitors in parallel (72, 73), connected at one end to a pressure-activated switch (74), which closes when the pressure received by said switch is greater than the first predetermined pressure threshold, or wherein the resonant circuit (65) includes a capacitor whose capacitance changes value when the pressure it receives is greater than the first predetermined pressure threshold, or wherein the resonant circuit (65) includes a coil whose inductance changes value when the pressure it receives is greater than the first predetermined pressure threshold.

3. Electromagnetic device (60) according to any of the preceding claims, wherein when the beacon is connected to two ends of ducts of the conduit through their openings (611, 612), the pressure in the pressure-sensitive resonant circuit element depends on the pressure received by the end of one of the ducts to which the electromagnetic device (60) is connected.

4. Electromagnetic device (60) according to any of the preceding claims, wherein the device (60) comprises a first part (61) having the two openings (611, 612) and the internal duct (81), wherein the orifice of the internal duct (81) allows the passage of air through a channel (82) to a pressure-measuring chamber located between this first part (61) and a membrane (62), and wherein this membrane deforms when the pressure in the chamber increases and transmits said pressure increase to the pressure-sensitive resonant circuit element.

5. Electromagnetic device (60) according to claim 4, wherein the device comprises a second part (63) attached to the first part (61) by means of a retention system, wherein the membrane (62) is located between both parts (61, 63) and wherein this second part (63) is attached to the housing (64).

6. Electromagnetic device (60) according to any one of claims 4 to 5, wherein the connection between the first part (61) and the second part (63) is made by means of a retention system that allows it to withstand pressures of up to 16 bar.

7. Electromagnetic device (60) according to any of the preceding claims, wherein each of the openings (611, 612) has a cylindrical shape and an outside diameter suitable for connecting to the ducts of the conduit.

8. Electromagnetic device (60) according to any of the preceding claims wherein the conduit is a conduit of an optical fiber network and the ducts to which the device is connected are microducts.

9. Method for performing calibration tests on ducts of a conduit, using the electromagnetic device (60) described in any of the preceding claims 1-8, wherein the method comprises:

   a) Connecting in a watertight manner, one of the openings (611) of the electromagnetic device (60) to one end of a first duct of the conduit and another of the openings (612) to one end of a second duct of the conduit;
   b) Introducing a piece with a predetermined caliber through the other end, not connected to the beacon (60), of the first conduit along with pressurized air;
   c) If the piece comes out of the end of the second duct not connected to the beacon (60), then determine that the result of the calibration test performed is positive.

10. Method for performing continuity verification tests and pressure tests on ducts of a conduit, using the electromagnetic device (60) described in any of the preceding claims 1-8, wherein the method comprises:

   a) Connecting in a watertight manner, one of the openings (611) of the electromagnetic device (60) to one end of a first duct of the conduit and another of the openings (612) to one end of a second duct of the conduit;
   b) Introducing pressurized air through the other end, not connected to the beacon (60), of the first duct;
   c) Detecting the resonance frequency of the electromagnetic device (60) and, if the resonance frequency has changed with respect to the resonance frequency of the device in the absence of pressurized air, then determine that the result of the test performed is positive.

11. Method according to claim 10, wherein the pressure in the pressure-sensitive resonant circuit element depends on the pressure at the end of the first duct to which the electromagnetic device (60) is connected, and wherein, in order to perform the pressure test at the same time as the continuity verification test, the first predetermined pressure threshold is sufficiently high so that the pressure in the element reaches that threshold when there is no leakage in the first duct, and wherein, if in step c) the resonant frequency has changed with respect to the resonant frequency of the device in the absence of pressurized air, then it is determined that not only the result of the continuity verification test but also the result of the pressure test is positive.

12. Method according to any of claims 10-11, wherein if in step c) the resonance frequency does not change, then the pressure is measured at the end of the duct through which pressurized air is introduced to determine whether it was a failure of the pressure test or the continuity verification test.

13. Method according to any of claims 9-12 above, wherein the conduit is a conduit of an optical fiber network and the ducts to which the device is connected are microducts.

14. Method according to claims 9-13, wherein step c) is performed, the electromagnetic device (60) being buried.

15. Method according to any of claims 9-14, wherein the conduit is a conduit of a fiber optic network and wherein the first duct is a duct that runs from the distribution point of the fiber optic network to the drop point to a dwelling, FTTF point or HP+, and the second duct is a duct that runs from said drop point to the end of the bundle of ducts or end of line (or routing).

FIG. 1

Private domain

Public domain

Electromagnetic beacon

FTTF Point

Drop microduct

Connector

Cap

Bundle of microducts

Individual breakout

Bundle of microducts

# FIG. 2

FIG. 3

FIG. 4

Distribution point

Bundle of microducts

101.4 KHz

51A

101.4 KHz

52A

101.4 KHz

53A

Bundle of microducts

55A

54

54

54

54

**FIG. 5A**

FIG. 5B

EP 4 779 330 A1

FIG. 5C

60

611

612

61

62

63

64

65

**FIG. 6**

71

72

73

74

**FIG. 7**

84

81    82    83

**FIG. 8**

91    92    93

**FIG. 9**

**FIG. 10**

# INTERNATIONAL SEARCH REPORT

| | International application No. |
|---|---|
| | PCT/ES2023/070556 |

### A. CLASSIFICATION OF SUBJECT MATTER

*G01R31/08* (2020.01)
*G01R31/50* (2020.01)
According to International Patent Classification (IPC) or to both national classification and IPC

### B. FIELDS SEARCHED

Minimum documentation searched (classification system followed by classification symbols)
G01R, G01S

Documentation searched other than minimum documentation to the extent that such documents are included in the fields searched

Electronic data base consulted during the international search (name of data base and, where practicable, search terms used)

EPODOC, INVENES, WPI, INSPEC, XPAIP, XPESP, XPI3E, XPI3ES, XPIEE, XPMISC, XPOAC

### C. DOCUMENTS CONSIDERED TO BE RELEVANT

| Category* | Citation of document, with indication, where appropriate, of the relevant passages | Relevant to claim No. |
|---|---|---|
| A | US 4862088 A (NOLF, JEAN-MARIE ETIENNE ET AL.) 29/08/1989, abstract; column 1, lines 6 -39; column 2, lines 18 - 65; column 5, Lines 16 - 36; column 6, line 39 - column 7, line 39; column 8, line 45 - column 9, line 13; column 11, lines 45 - 48; column 14, lines 8 - 25; figure 2, figure 6, figure 13, figure 29; claims 1-2; claim 29. | 1-15 |
| A | HOPSTER, J.: "Pruebas de presión en una canalización de fibra óptica". Esders, 31/01/2022 [on line][retrieved the 22/05/2024]. Retrieved from <URL: https://www.esders.es/2022/01/pruebas-presion-canalizacion-fibra-optica/>. | 1-15 |

☐ Further documents are listed in the continuation of Box C.      ☒ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance. | | |
| "E" | earlier document but published on or after the international filing date | | |
| "L" | document which may throw doubts on priority claim(s) or which is cited to establish the publication date of another citation or other special reason (as specified) | "X" | document of particular relevance; the claimed invention cannot be considered novel or cannot be considered to involve an inventive step when the document is taken alone |
| "O" | document referring to an oral disclosure use, exhibition, or other means. | "Y" | document of particular relevance; the claimed invention cannot be considered to involve an inventive step when the document is combined with one or more other documents , such combination being obvious to a person skilled in the art |
| "P" | document published prior to the international filing date but later than the priority date claimed | | |
| | | "&" | document member of the same patent family |

| Date of the actual completion of the international search | Date of mailing of the international search report |
|---|---|
| 22/05/2024 | **(27/05/2024)** |

| Name and mailing address of the ISA/ <br><br> OFICINA ESPAÑOLA DE PATENTES Y MARCAS       Paseo de la Castellana, 75 - 28071 Madrid (España) <br> Facsimile No.: 91 349 53 04 | Authorized officer <br> E. Pina Martínez <br><br><br> Telephone No. 913498552 |

Form PCT/ISA/210 (second sheet) (July 2022)

## INTERNATIONAL SEARCH REPORT

Information on patent family members

| Patent document cited in the search report | Publication date | Patent family member(s) | Publication date |
|---|---|---|---|
| US4862088 A | 29.08.1989 | JPS6195257 A | 14.05.1986 |
| | | EP0182488 A1 | 28.05.1986 |
| | | EP0182488 B1 | 05.09.1990 |
| | | CA1269547 A | 29.05.1990 |
| | | ATE56279T T1 | 15.09.1990 |

Form PCT/ISA/210 (patent family annex) (July 2022)